# EUROPÄISCHE PATENTSCHRIFT

(11) **EP 3 267 410 B1**
(45) Veröffentlichungstag und Bekanntmachung des Hinweises auf die Patenterteilung: **20.03.2019**
(21) Anmeldenummer: 17001146.4
(22) Anmeldetag: 05.07.2017
(51) Int. Cl.: G08B 13/26, H03K 17/955

(54) **ELEKTRONISCHES SENSORSYSTEM FÜR DAS DETEKTIEREN VON BEWEGUNG ODER LAGEVERÄNDERUNG VON MATERIE**
ELECTRONIC SENSOR SYSTEM FOR DETECTING MOVEMENT OR MODIFYING THE POSITION OF MATTER
SYSTÈME DE CAPTEUR ÉLECTRONIQUE POUR DÉTECTER LE MOUVEMENT OU LA MODIFICATION DE POSITION DE MATIÈRE

(30) Priorität: 07.07.2016 AT 3192016
(43) Veröffentlichungstag der Anmeldung: 10.01.2018
(73) Patentinhaber: trailerfox gmbH, 4551 Ried im Traunkreis (AT)
(72) Erfinder: Niederndorfer, Friedrich, 4863 Seewalchen am Attersee (AT); Sällberg, Ulf Hakan Benny, 4840 Vöcklabruck (AT)

(56) Entgegenhaltungen:
- EP-A1- 0 199 250
- WO-A1-88/05950
- WO-A1-97/41458
- US-A1- 2014 267 157

## Beschreibung

Die Erfindung betrifft ein elektronisches Sensorsystem für das Detektieren von Bewegung oder Lageveränderung von Materie in einem zu überwachenden Raumbereich.

Das Sensorsystem basiert auf jenem gängigen Funktionsprinzip elektronischer Näherungs- und/oder Bewegungssensoren, entsprechend welchem die veränderbare Frequenz oder die veränderbare Phase der elektrischen Spannung an einer schwingungsfähigen elektrischen Schaltung gemessen wird, deren Schwingungsfrequenz von mindestens einer Kapazität und einer Induktivität abhängig ist, wobei sich zumindest eines der mit diesen Bauteilen einhergehenden Felder (elektrisches Feld bzw. Magnetfeld) in den zu überwachenden Raumbereich erstreckt und damit veränderbar ist, dass sich in diesem Raumbereich eine Masse bewegt.

Dazu seien aus der Patentliteratur die folgenden Beispiele vorgestellt:
Die WO9402917 A1 beschreibt eine Überwachungseinrichtung, gemäß welcher eine an einer Antenne anliegende Frequenz durch Umgebungsbedingungen an der Antenne - wie beispielsweise das Annähern eines Fahrzeuges - veränderbar ist. Über jeweils eine bestimmte Zeitperiode werden die Schwingungen des Antennensignals gezählt, das Zählergebnis ausgewertet und dann rückgesetzt. Abweichung des Zählergebnisses um einen Mindestbetrag von einem bestimmten vorgegebenen Wert bedeutet ein Detektionsergebnis das zu einer Alarmauslösung führt.

Die JP2004206373 A beschreibt eine Schwingkreisschaltung, welche die Induktivität oder Kapazität an einer Fensteröffnung miteinbezieht und deren Resonanzfrequenz davon abhängig ist. Die Resonanzfrequenz wird ständig überwacht. Eine Veränderung der Resonanzfrequenz - wie sie beispielsweise durch das Eindringen eines Menschen durch die Fensteröffnung - ausgelöst werden kann, löst einen Alarm aus.

Die US 2013/0234729 A1 zeigt einen Bewegungssensor, welcher nicht auf der Änderung einer Kapazität oder Induktivität in einem zu überwachenden Raumbereich basiert, sondern auf der Reflexion von Mikrowellenstrahlung an einem in dem Raum befindlichen beweglichen Objekt, wozu die Phasenverschiebung und/oder der Frequenzunterschied zwischen dem ausgesandten und dem am Objekt reflektierten Signal gemessen und ausgewertet wird. Die Auswertungsschaltung umfasst einen spannungskontrollierten Oszillator, einen Referenzoszillator und einen Regler die gemeinsam eine Phasenregelschleife (engl. "PLL" für "phase-looked loop") bilden. Um einen störenden Gleichspannungsanteil, welcher sich im Fall einer Detektion am Ausgangssignal des Reglers aufbaut, abzubauen, wird gegebenenfalls die Regelschleife temporär unterbrochen und am spannungskontrollierten Oszillator anstatt des Ausgangssignals des Reglers eine separate, korrigierende Eingangsspannung angelegt.

Gemäß der EP 1360668 B1 weist ein Sensorsystem zwei Elektroden auf, die gemeinsam eine elektrische Kapazität bedeuten, wobei sich das zwischen ihnen aufgebaute elektrische Feld in den zu überwachenden Raumbereich erstreckt. Das Sensorsystem weist einen spannungsgesteuerten Oszillator (Kurzbezeichnung "VCO" für "voltage controlled oscillator") auf, dessen Frequenz einerseits von der besagten Kapazität abhängig ist, andererseits durch eine Steuerspannung veränderbar ist, sodass sie bei Änderung besagter Kapazität durch passende Änderung der Steuerspannung wieder auf einen Sollwert hin ausgeregelt werden kann. Weiters weist das Sensorsystem einen Referenzoszillator auf, welcher ein elektrisches Signal mit verlässlich konstant gehaltener Frequenz liefert. Die beiden Oszillatoren sind gemeinsam mit einer "Vergleichsschaltung", deren Ausgangsspannung mit Phasenverschiebung zwischen den Schwingungen der beiden Oszillatoren steigt, und einer Steuerspannungsquelle, deren abgegebene Spannung von der an ihrem Eingang anliegenden Ausgangsspannung der Vergleichsschaltung abhängig ist, zu einem Regelkreis zusammengeschaltet. In dem Regelkreis wird die Frequenz des spannungsgesteuerten Oszillators konstant gleich der Frequenz des Referenzoszillators gehalten und die Phasenverschiebung in den Signalen der beiden Oszillatoren auf einen konstanten Sollwert hin ausgeregelt, auch wenn sich jene Kapazität des Oszillators, dessen elektrisches Feld sich in den zu überwachenden Raumbereich erstreckt, ändert. Die Kombination aus spannungsgesteuertem Oszillator, Referenzoszillator und Regler, welcher die Phasenverschiebung auf einen konstanten Wert hin ausregelt, wird als "PLL" für "phase-looked loop" (deutsch "Phasenregelschleife") bezeichnet. Das über die Zeit auf integrierte Ausgangssignal der Vergleichsschaltung wird als Ausgangssignal des Sensorsystems verwendet; es zeigt an, dass sich etwas in den überwachten Raumbereich hineinbewegt hat oder sich darinnen bewegt hat.

Auch die US 4169260 A zeigt eine als Näherungsdetektor arbeitende Schaltungsanordnung, welche auf dem Prinzip basiert dass sich die Frequenz einer schwingungsfähigen elektrischen Schaltung ändert, wenn sich eine Person einem kapazitiven Schaltungselement nähert und dessen Kapazität dadurch verändert und wobei die Phasenverschiebung zwischen einer Schwingung die durch Annäherung einer Person verändert wird und einer Referenzschwingung zu einem Signal weiterverarbeitet wird. Dabei ist auch ein Regelkreis vorhanden, welcher die Frequenz jener schwingungsfähigen Schaltung deren Frequenz durch Annäherung einer Person veränderbar ist, auf einen festgelegten Sollwert hin ausregelt. Als schwingungsfähige Schaltung wird dabei wiederum ein VCO verwendet, also ein Oszillator, dessen Schwingungsfrequenz durch die an einem Steuereingang anliegende Spannung einstellbar ist. Aus jenem Signal aus welchem das Signal generiert wird, welches am Steuereingang des VCO angelegt wird um dessen Frequenz immer wieder auf den Sollwert hin zu regeln, wird auch jenes Signal generiert, welches die zu detektierende Näherung anzeigt.

Die EP 2 683 084 A2 beschreibt eine elektronische Warnvorrichtung gegen das Eindringen von Personen in einen abzusichernden Bereich wobei die Warnvorrichtung eine Schaltung aufweist, in welcher die Schwebung zwischen zwei hochfrequenten elektrischen Signalen, von denen eines konstante Referenzfrequenz hat und das zweite in seiner Frequenz veränderbar ist, ausgewertet und/oder hörbar gemacht wird. Das in seiner Frequenz veränderbare Signal wird durch einen VCO generiert, welcher neben einer Kapazität auch eine Induktivität aufweist, welche als Spule um einen ferromagnetischen Ringkern ausgebildet ist, durch welchen als eine zusätzliche Wicklung eine isolierte elektrische Leitung hindurch verläuft, welche den abzusichernden Bereich umringt. Bewegung von Massen in Nahbereich der Leitung bewirkt Veränderung des elektrischen Wechselfeldes und/oder des magnetischen Wechselfeldes an der Leitung. Diese Veränderungen wirken sich als Veränderung der für die schwingungsfähige Schaltungsanordnung wirksamen Induktivität aus und damit in weiterer Folge als Veränderungen der Frequenz des durch die Schaltungsanordnung generierten Hochfrequenzsignals. Die Frequenz des VCO wird in regelmäßigen Abständen durch passendes Verändern der am Steuereingang des VCO anliegenden Spannung der Referenzfrequenz nachgeregelt, sodass eine sogenannte FLL (Frequency-locked Loop; deutsch "frequenzverriegelte Schleife") gebildet wird.

An sich hat sich das Sensorsystem gemäß der EP 2 683 084 A2 entsprechend welchem die Eigenfrequenz eines elektrischen Hochfrequenzoszillators durch eine elektrische Leitung veränderbar ist, welche in oder an den zu überwachenden Raumbereich führt, als sehr vorteilhaft herausgestellt, weil es bezogen auf den Aufwand sehr empfindlich ist und sehr flexibel einsetzbar ist. Bei genaueren Untersuchungen wurde jedoch als Schwäche erkannt, dass die Sensibilität des Sensorsystems entlang der an bzw. in den zu überwachenden Raumbereich führenden elektrischen Leitung keineswegs konstant ist, sondern in Abhängigkeit von der Position entlang der Leitung störend stark schwankt. Es gibt Bereiche, bei denen die Sensibilität sehr gut ist - also die Veränderbarkeit der Schwingungsfrequenz durch Bewegung von Massen im Nahbereich der Leitung sehr deutlich ist - und Bereiche, bei denen die Sensibilität sehr niedrig ist, also kaum Veränderbarkeit der Schwingungsfrequenz durch Bewegung von Massen im Nahbereich der Leitung erkennbar ist. Wenn als Kompensation von letzterem die Auslöseschwelle für die Anzeige einer Bewegung im überwachenden Raumbereich so niedrig eingestellt wird, dass es auch bei Bewegung an den Bereichen mit niedriger Sensibilität zu verlässlicher Auslösung kommt, können schon an sich unbedeutende kleine Bewegungen an anderen Leitungsbereichen zu Detektionssignalen führen.

Die der Erfindung zu Grunde liegende Aufgabe besteht darin, diesen Nachteil zu beheben, nämlich ein elektronisches Sensorsystem für das Detektieren von Bewegung oder Lageveränderung von Masse im Umgebungsbereich einer elektrischen Leitung bereitzustellen, wobei erreichbar sein soll, dass die Sensibilität der Detektion entlang der Leitung nirgends störend stark abfällt.

Für das Lösen der Aufgabe wird vorgeschlagen das bekannte Funktionsprinzip elektronischer Näherungs- und/oder Bewegungssensoren, anzuwenden, wonach das als elektrische Wechselspannung mit veränderbarer Frequenz oder mit veränderbarer Phase vorliegende Ausgangssignal einer schwingungsfähigen elektrischen Schaltung mit einem Referenzsignal konstanter Frequenz verglichen wird, wobei die Schwingungsfrequenz der schwingungsfähigen elektrischen Schaltung sowohl durch eine an einem Eingang anliegende elektrische Spannung verstellbar ist, als auch durch Änderung von mindestens einer Kapazität und/oder Induktivität, deren Größe dadurch beeinflussbar ist, dass Masse im Nahbereich einer Leitung bewegt oder lageverändert wird, wobei im Rahmen einer Regelung die am Eingang der schwingungsfähigen Schaltung anliegende Spannung derart laufend eingestellt wird, dass die Frequenz des Ausgangssignals der schwingungsfähigen elektrischen Schaltung auf die Frequenz des Referenzsignals als Sollwert hin ausgeregelt wird.

Als erfindungsgemäße Weiterentwicklung dazu wird vorgeschlagen, als Frequenzwert des Referenzsignals und damit auch als Sollwert der Frequenz der schwingungsfähigen elektrischen Schaltung, mehrere unterschiedliche Frequenzwerte vorzusehen, wobei die unterschiedlichen Frequenzwerte zeitlich getaktet hintereinander angewendet werden.

Der erfindungsgemäßen Maßnahme liegt die aufhellende Erkenntnis zu Grunde, dass sich jene Bereiche an der in den zu überwachenden Raumbereich erstreckenden Leitung, in denen das Sensorsystems wenig sensibel gegen Bewegung von Masse ist, dann entlang der Leitung verschieben, wenn sich die Frequenz des in der Leitung transportierten elektrischen Signals ändert. Indem nun gezielt bei mehreren zueinander unterschiedlichen Frequenzen detektiert wird, ist damit erreichbar, dass an jeden Raumbereich entlang der Leitung zumindest bei einer der Frequenzen gute Sensibilität für das Detektieren von Massebewegung vorliegt.

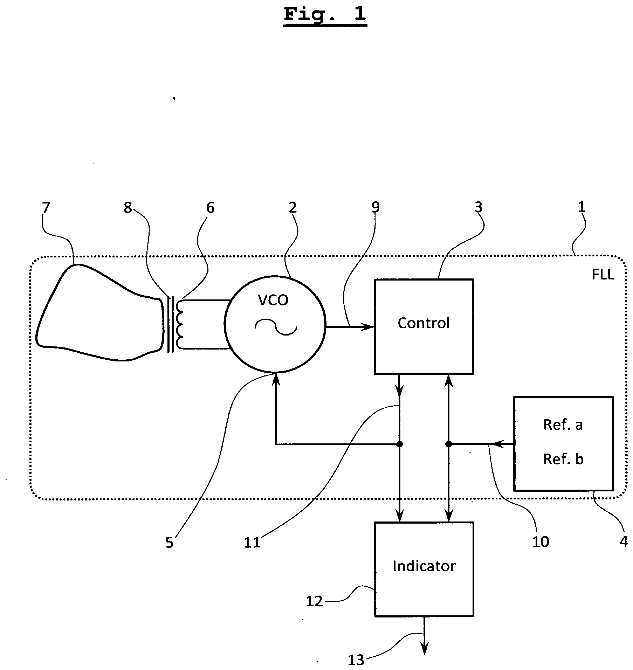

### Fig. 1: zeigt ein Blockschaubild eines beispielhaften erfindungsgemäßen Sensorsystems

Das in Fig. 1 skizzierte, beispielhaften erfindungsgemäßen Sensorsystem enthält eine durch eine punktierte Umrahmung symbolisierte FLL 1. ("FLL" steht für Frequency-locked Loop; zu deutsch "frequenzverriegelte Schleife, also einen Regelkreis in welchem eine schwingungsfähige elektrische Schaltung dahingehend geregelt wird, dass ihre Schwingungsfrequenz konstant gehalten wird.)

Die wesentlichen Teile der FLL 1 sind ein VCO 2, ein Regler 3, und ein Sollwertgeber 4.

Der VCO 2, ist definitionsgemäß ein elektrischer Oszillator, dessen Schwingungsfrequenz von einer an einem Steuereingang 5 anliegenden Spannung abhängig ist und somit durch Verstellung dieser Spannung einstellbar ist. Teil des VCO 2 ist eine Induktivität 6, deren Größe ebenso auf die Schwingungsfrequenz des VCO 2 Einfluss hat. Die Induktivität 6 ist - bei der skizzierten vorteilhaften Ausführung - transformatorisch mit einer als geschlossene Schleife ausgebildeten Leitung 7 gekoppelt, sodass die wirksame Größe der Induktivität 6 vom elektrischen Zustand der Leitung 7 abhängig ist. Die transformatorische Kopplung zwischen der Induktivität 6 und der Leitung 7 erfolgt, indem die beiden Elemente jeweils Wicklung um einen gemeinsamen ferromagnetischen Kern 8 sind. Dabei reicht es, wenn die Leitung 7 nur eine einzige Windung darstellt.

Im Bereich hochfrequenter Wechselspannungssignale um die es beim VCO 2 geht, ist die Leitung 7 nicht einfach nur ein Kurzschluss, sondern eine ohmsche, kapazitive und induktive Last, wobei die induktive und die kapazitive Eigenschaft dieser Last von Anordnung und Art von Materie in der Umgebung der Leitung 7 abhängig ist. Das ist deswegen so, weil der Fluss des durch die Spannung bzw. Strom in der Leitung 7 hervorgerufenen, sich in der Umgebung der Leitung 4 ausbreitenden elektrischen bzw. magnetischen Wechselfeldes in Abhängigkeit von der dort befindlichen Materie vergrößert bzw. verkleinert wird, womit auch die wirksame Kapazität bzw. Induktivität der Leitung 7 vergrößert bzw. verkleinert wird. Indem damit bei Bewegung von Materie im Umgebungsbereich der Leitung 7 deren Induktivität und/oder Kapazität verändert wird und diese Veränderung durch transformatorische Kopplung auf die Induktivität 6 rückwirkt, bewirkt besagte Bewegung von Materie eine Veränderung der Schwingungsfrequenz des VCO 2.

Die konkrete schaltungstechnische Ausführung des VCO 2, einschließlich der Elemente Induktivität 6, Leitung 7, und ferromagnetischem Kern 8 ist für Fachleute auf dem Gebiet der Elektronik im Rahmen ihres fachmännischen Handelns festlegbar, weswegen hier nicht weiter darauf eingegangen wird. Konkrete Festlegungen für Schaltungselemente können beispielsweise auch der oben abgehandelten EP 2 683 084 A2 entnommen werden.

Das Ausgangssignal 9 des VCO 2 ist eine Wechselspannung, deren Frequenz die Schwingungsfrequenz des VCO 2 ist. Dieses Ausgangssignal 9 wird als Regelgröße an den dafür bestimmen Eingang des Reglers 3 geleitet. Am Eingang des Reglers 3 für die Führungsgröße (Sollwert) liegt das Referenzsignal 10 an, welches von dem Sollwertgeber 4 erzeugt wird und eine Wechselspannung mit jenem Frequenzwert ist, mit dem auch der VCO 2 schwingen soll.

Im Regler 3 wird - wie an sich bei jeden Regler für eine FLL - mit schaltungstechnischen Mitteln eine die Differenz der Frequenzen der beiden Eingangssignale repräsentierende Größe erzeugt und aus dieser Größe ein Ausgangssignal 11 erzeugt, welches als Stellgröße an den Steuereingang 5 des VCO 2 geleitet wird und so bemessen ist, dass es die Frequenz des VCO dahingehend verändert, dass dieser der Frequenz des Referenzsignals 10 möglichst gleich wird.

Auch bezüglich des Reglers 3 gilt, dass die konkrete schaltungstechnische Ausführung für Fachleute auf dem Gebiet der Elektronik im Rahmen ihres fachmännischen Handelns festlegbar, weswegen hier nicht weiter darauf eingegangen zu werden braucht.

Das Ausgangssignal 11 des Reglers 3 wird nicht nur an den VCO 2 geleitet, sondern auch als Eingangsgröße an die Indikatorschaltung 12. Diese Schaltung extrahiert aus Größe und/oder Schwankungen dieses als Spannung vorliegenden Signals eine weitere, beispielsweise binäre Ausgangsgröße 13, welche je nach Wert aussagt ob zu meldende Bewegung im Bereich der Leitung 7 stattgefunden hat oder nicht. Auch die konkrete schaltungstechnische Verwirklichung dieses Extrahieren ist für Fachleute auf dem Gebiet der Elektronik im Rahmen ihres fachmännischen Handelns festlegbar weswegen hier nicht detailliert darauf eingegangen zu werden braucht. Beispielsweise kann für dieses Extrahieren das Eingangssignal oder ein davon abgeleitetes Signal wiederholend über eine kurze Zeitdauer festgelegter Länge aufintegriert werden, und dabei Überschreiten des integrierten Wertes über einen Schwellwert als Indikation von zu meldender Bewegung an der Leitung 7 gedeutet werden.

Erfindungsgemäß wesentlich ist, dass das Referenzsignal 10 nicht eine immerwährend gleichbleibende Referenzfrequenz signalisiert, sondern mindestens zwei zueinander verschiedene Referenzfrequenzen, welche in einem festgelegten zeitlichen Takt abwechselnd ausgewählt und als Führungsgröße an den Regler 3 gesendet werden. Damit die FLL funktionieren kann, muss die Taktfrequenz des Wechselns zwischen den verschiedenen Referenzfrequenzen sehr viel geringer sein, als die Referenzfrequenzen selbst sind. Beispielsweise kann zwischen den Referenzfrequenzen 13,56 MHz und 6,78 MHz gewechselt werden, wobei die Frequenz des Wechselns bei 2 kHz liegt, also weniger als ein Dreitausendstel der niedrigeren Referenzfrequenz beträgt.

Durch den Wechsel der Frequenzen auf welche die Schwingungsfrequenz der VCO 2 hin geregelt wird, wechselt auch die Frequenz der Spannung bzw. des Stromes in der Leitung 7. Wie schon oben erwähnt wird damit erreicht, dass an jeden Raumbereich entlang der Leitung 7 zumindest bei einer der verwendeten Referenzfrequenzen gute Sensibilität für das Detektieren von Massebewegung vorliegt.

Die Leitung 7 muss eine bevorzugt niederohmige elektrische Verbindung zwischen zwei Anschlusspunkten darstellen. Für gute Sensibilität des Sensorsystems sollte sie gegenüber der Umgebung die es zu überwachen gibt, elektrisch isoliert sein. Sie kann beispielsweise als isolierte elektrische Leitung ganz herkömmlicher Bauart, also ein mit einer Isolierung ummantelter metallischer Draht ausgebildet sein. Es sind aber auch viele andere Bauarten denkbar und für manche Anwendungsfälle auch vorteilhaft. Beispielsweise kann die Leitung 7 eine Leiterschleife auf einer Leiterplatte sein. Die Leitung 7 kann auch ein flächiges und oder räumliches Metallgebilde wie Gitter, Gewebe, Vlies, Metallplatte oder Gehäuse sein.

An der "nur" transformatorischen und nicht unmittelbar elektrisch leitenden Verbindung der Leitung 7 mit dem Rest des VCO 2 ist vor allem die damit einhergehende Potentialtrennung vorteilhaft; es können also keine zerstörerischen Überspannungen von der Leitung 7 an die Schaltung gelangen und auch elektrische Verbindung der Leitung 7 mit der Umgebung führt nicht zwangsweise zu einem unmittelbaren Versagen der Schaltung oder einem Kurzschluss.

Es ist aber keineswegs zwingend erforderlich, die Leitung 7 nur transformatorisch mit dem Rest der Schaltung zu verbinden. Es kann sogar vorteilhaft sein, die Verbindung direkt elektrisch leitend auszuführen. An der direkten Verbindung ist vor allem die höhere Genauigkeit bei der Reproduktion der Funktion als Vorteil zu nennen.

Es ist vorteilhaft, das Referenzsignal 10 in der Indikatorschaltung 12 dazu heranzuziehen, das Extrahieren der Ausgangsgröße 13 zeitlich mit dem Takt des Wechsels der Referenzfrequenzen zu synchronisieren, da damit Einschwingvorgänge des Regelkreises um die VCO die jeweils unmittelbar nach dem Wechsel der Referenzfrequenzen stattfinden, ausgeklammert werden können.

Ohne Anspruch auf Vollständigkeit seien im Rahmen des Erfindungsgedankens liegende Abwandlungen von der in Fig. 1 skizzierten und beschriebenen Funktionsweise kurz genannt.

Anstatt einer als FLL (Frequency-locked Loop; deutsch "frequenzverriegelte Schleife") ausgebildeten Regelschleife kann auch eine als PLL ("phase-looked loop" deutsch "Phasenregelschleife") ausgebildete Regelschleife verwendet werden, also eine Phasenverschiebung zwischen der VCO 2 und einem Referenzsignal nachgeregelt werden, wobei allerdings dennoch zwischen Referenzsignalen und damit auch VCO-Schwingungen mit mindestens zwei zueinander unterschiedlichen Frequenzen gewechselt werden muss.

Anstatt eine einzige VCO mit zwei verschiedenen Referenzfrequenzen anzuwenden, können auch zwei VCO verwendet werden, welche mit der gleichen Leitung (7) zusammenwirken und zeitlich abwechselnd mit unterschiedlichen Frequenzen betrieben werden, wobei die Referenzfrequenz für jede einzelne VCO immer gleich bleiben kann. Die in Fig. 1 skizzierte VCO wäre also in Wirklichkeit aus zwei internen VCO aufgebaut, wobei mit dem Wechsel der Referenzfrequenz auch wechselt welche interne VCO in Betrieb ist.

Das erfindungsgemäße Sensorsystem ist extrem einfach und verlässlich funktionierend für viele verschiedene Anwendungsfälle wahlweise anwendbar ohne dass für den Wechsel zwischen verschiedenen Anwendungsfällen Hilfe durch Fachleute erforderlich ist. Es braucht immer nur die Leitung 7 in bzw. an oder um den zu überwachenden Raumbereich gelegt zu werden.

Ohne Anspruch auf Vollständigkeit seinen als Beispiele für Anwendungen kurz genannt:
An einem Saunaofen kann automatisch erkannt werden ob sich ein Handtuch im Gefahrenbereich durch die Hitze des Ofens befindet, indem die Leitung 7 in diesen Gefahrenbereich geführt wird.

Zutritt zu einem Boot kann automatisch überwacht werden indem die Leitung 7 entlang der Reling des Bootes oder überhaupt als Reling des Bootes geführt wird.

Beim Campieren kann eine automatische, sehr gut sensitive und selektive Zutrittsüberwachung realisiert werden, indem die Leitung 7 um den Lagerplatz herum gelegt wird.

Ausstellungsobjekte in Museen, Galerien etc. können gesichert werden indem die Leitung 7 in deren Nahbereich geführt wird.

Zutritt bzw. Eintritt von Menschen oder Tieren zu Objekten wie Hochständen für die Jagd, Schwimmbecken, Baustellenausrüstung, etc. kann einfach und rasch realisiert werden, indem am jeweiligen Bereich die Leitung 7 ausgelegt wird.

Es können auch Garten- oder sonstige Grundstücksbereiche gegen Zutritt von fremden Tieren (Katzen, Hunde die ausgeführt wurden um ihre Notdurft zu verrichten, Raubtiere die Haustiere bedrohen...) gesichert werden indem (des Nachts) die Leitung 7 an diesen Bereichen ausgelegt wird und das Sensorsystem für das Auslösen einer Abschreckeinrichtung (Schallquelle, Lichtquelle) verwendet wird.

Das Sensorsystem kann für Bewegungsspiele verwendet werden, indem die Leitung 7 ausgelegt wird und beispielsweise aus dem Nahbereich der Leitung Gegenstände entfernt werden müssen, ohne ein Detektionssignal auszulösen.

## Patentansprüche

1. Elektronisches Sensorsystem für das Detektieren von Bewegung oder Lageveränderung von Materie in einem zu überwachenden Raumbereich,
wobei ein spannungsgesteuerter Oszillator (2), ein Regler (3) und ein Sollwertgeber (4) einen Regelkreis bilden, der dazu eingerichtet ist, die Frequenz des Ausgangssignals (9) des spannungsgesteuerten Oszillators (2) der konstanten Frequenz eines durch einen Sollwertgeber (4) generierten Referenzsignals (10) nachzuregeln und/oder die Phasenverschiebung des Ausgangssignals (9) gegenüber dem Referenzsignal (10) an einen festgelegten Sollwert anzunähern,
wobei das Ausgangssignal (11) des Reglers (3) auch Eingangssignal einer Indikatorschaltung (12) ist, die dazu ausgelegt ist, aus diesem Eingangssignal eine Ausgangsgröße (13) zu extrahieren, die je nach Wert ein Detektionsergebnis bedeutet oder nicht,
wobei die Schwingungsfrequenz des spannungsgesteuerten Oszillators (2) durch Änderung von mindestens einer Kapazität und/oder Induktivität (6) beeinflussbar ist, deren Größe dadurch beeinflussbar ist, dass Masse im Nahbereich einer Leitung (7) bewegt oder lageverändert wird,
**dadurch gekennzeichnet, dass**
die Frequenz des Referenzsignals (10) in einem festgelegten zeitlichen Takt zwischen mindestens zwei zueinander verschiedene Referenzfrequenzen wechselt.

2. Sensorsystem nach Anspruch 1, **dadurch gekennzeichnet, dass** die Leitung (7) transformatorisch mit der zum VCO (2) gehörenden Induktivität (6) gekoppelt ist.

3. Sensorsystem nach Anspruch 1, **dadurch gekennzeichnet, dass** die kleinste Frequenz des Referenzsignals (10) mindestens tausendfach höher ist als die Taktfrequenz des Wechsels zwischen unterschiedlichen Referenzfrequenzen.

## Claims

1. Electronic sensor system for detecting movement or change of position of matter within an area to be monitored,
wherein a voltage-controlled oscillator (2), a regulator (3) and a set point generator (4) form a control circuit which is adapted to control the frequency of the output signal (9) of the voltage-controlled oscillator (2) of the constant frequency of a reference signal (10) generated by a set point generator (4) and/or approximate the phase shift of the output signal (9) relative to the reference signal (10) to a defined set point,
wherein the output signal (11) of the regulator (3) is also an input signal of an indicator circuit (12) which is designed to extract from this input signal an output quantity (13) which, depending on the value, means a detection result or not,
wherein the oscillation frequency of the voltage-controlled oscillator (2) can be influenced by changing at least one capacitance and/or inductance (6) the size of which can be influenced by moving or changing position in the vicinity of a wire (7),
**characterised in that**
the frequency of the reference signal (10) changes in a fixed time cycle between at least two mutually different reference frequencies.

2. Sensor system according to claim 1, **characterised by** the fact that the wire (7) is coupled by transformer with the inductance (6) belonging to the VCO (2).

3. Sensor system according to claim 1, **characterised by** the fact that the smallest frequency of the reference signal (10) is at least one thousand times higher than the clock frequency of the change between different reference frequencies.

## Revendications

1. Système de capteur électronique pour détecter le mouvement ou la modification de position de matière dans une zone à surveiller,
dans lequel un oscillateur commandé en tension (2), un régulateur (3) et un émetteur de valeur de consigne (4) forment un circuit de contrôle qui est agencé de façon à régler la fréquence du signal de sortie (9) de l'oscillateur commandé en tension (2), la fréquence constante d'un signal de référence (10) généré par un émetteur de valeur de consigne (4) et/ou pour rapprocher le décalage de phase du signal de sortie (9) par rapport au signal de référence (10) à une valeur de consigne définie,
dans lequel le signal de sortie (11) du régulateur (3) est également le signal d'entrée d'un circuit indicateur (12) qui est conçu pour extraire à partir de ce signal d'entrée une valeur de sortie (13) qui, en fonction de la valeur, signifie ou non un résultat de détection,
dans lequel la fréquence de vibration de l'oscillateur commandé en tension (2) peut être influencée par la modification d'au moins une capacitance et/ou inductance (6), dont la valeur peut être influencée par le déplacement ou la modification de position d'une masse à proximité d'un câble (7).
**caractérisé en ce que**
la fréquence du signal de référence (10) alterne, selon une cadence déterminée, entre au moins deux fréquences de référence différentes.

2. Système de capteur selon la revendication 1, **caractérisé en ce que** le câble (7) est couplé par transformateur à l'inductance (6) appartenant au VCO (2).

3. Système de capteur selon la revendication 1, **caractérisé en ce que** la plus petite fréquence du signal de référence (10) est au moins mille fois supérieure à la cadence de l'alternance entre les différentes fréquences de référence.
